# EUROPEAN PATENT APPLICATION

(11) **EP 4 593 077 A1**
(43) Date of publication of application: **30.07.2025**
(21) Application number: 24154094.7
(22) Date of filing: 26.01.2024
(51) Int. Cl.: H01L 23/433, H01L 23/495

(54) **DUAL COOLED MOSFET FOR LOW RDSON AND LOW THERMAL RESISTANCE**

(71) Applicant: Nexperia B.V., 6534 AB Nijmegen (NL)
(72) Inventor: Yandoc, Ricardo, Manchester, SK7 5BJ (GB); Estacio, Maria Cristina, Cabuyao (PH); Subida Jr., Emmanuel, Cabuyao (PH); Silva, Richmon, Cabuyao (PH)
(74) Representative: Pjanovic, Ilija

(57) **Abstract**

A semiconductor package and a method of manufacturing such semiconductor package are presented. The semiconductor package includes a first terminal exposed on a back surface of the semiconductor package, one or more further terminals extending outside the semiconductor package, and a second terminal exposed on a top surface of the semiconductor package. The second terminal includes a slug acting as the second terminal. The slug is electrically attached to the first terminal via one or more bended ends of the slug. The slug comprises one or more stress relief features.

## Description

### Technical field

The present disclosure relates to semiconductor packages, in particular metal-oxide-semiconductor field-effect transistors (MOSFETs), including a dual cooled configuration. The present disclosure further relates to a process for manufacturing such semiconductor package.

### Background

Power MOSFET packages and products that requires low RDSon, low inductance and low thermal resistance are becoming increasingly important, e.g., within the automotive industry.

One way of improving the product thermal resistance is by adding a slug on clip source interconnects and then expose this on the top surface of the package. Product electrical resistance and inductance may be achieved by flipping a die (source down), making the source cells directly attached on a PCB board. On the other hand, having an exposed drain terminal on the top surface of the package while in source down configuration typically gives more benefits on thermal performance.

However, introducing low thermal resistance gives additional challenges in exposing the top surface of the package. Known methods of exposing a slug on the top surface of a package typically include additional process steps such as package grinding or require additional material and systems such as film assist moulding. Moreover, known methods introduce risks of damaging the package due to lack of stress relief during moulding and package grinding.

### Summary

A summary of aspects of certain examples disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

The present disclosure aims to overcome the drawbacks identified in the background section.

According to an aspect of the present disclosure, a semiconductor package is presented. The semiconductor package may include a first terminal exposed on a back surface of the semiconductor package. The semiconductor package may further include one or more further terminals extending outside the semiconductor package. The semiconductor package may further include a second terminal exposed on a top surface of the semiconductor package. The second terminal may include a slug acting as the second terminal. The slug may be electrically attached to the first terminal via one or more bended ends of the slug. The slug may include one or more stress relief features.

In an embodiment, the one or more stress relief features may include one or more of: a half-cut feature at a transition from a top surface of the slug to the one or more bended ends; a half-cut feature located on a side of the one or more bended ends; a groove or similar feature.

In an embodiment, the one or more bended ends may be bended at an angle to a top surface of the slug, preferably at a perpendicular angle, optionally including a portion that is bended further outwards.

In an embodiment, the one or more bended ends may form legs of the slug.

In an embodiment, the first terminal may be formed by a paddle die. The paddle die may include one or more recessed surfaces for receiving the one or more bended ends. The one or more bended ends may be solder printed to the one or more recessed surfaces.

In an embodiment, a first surface of the slug may be exposed on the top surface of the semiconductor package, while a second surface of the slug may be facing towards a semiconductor silicon die before moulding.

In an embodiment, the first surface of the slug may be exposed on the top surface of the semiconductor package through direct or indirect touch with mould cavities.

In an embodiment, a first surface of the slug, if not contacting a top mould cavity, may have been exposed using a package grinding process.

In an embodiment, the first terminal may include a first surface exposed at the back of the semiconductor package. The first terminal may include a second surface acting as die paddle for a flipped semiconductor die.

In an embodiment, the semiconductor package may further include one or more further terminals extending outside the semiconductor package and formed in either a gull wing or micro leads, or leadless, or in a combination of both geometries.

In an embodiment, the first terminal and the second terminal may be source terminals. The one or more further terminals may include one or more drain terminals and one or more gate terminals.

In an embodiment, the first terminal and the second terminal may be drain terminals. The one or more further terminals may include one or more source terminals and one or more gate terminals.

In an embodiment, the semiconductor package may form a metal-oxide-semiconductor field-effect transistor (MOSFET).

According to an aspect of the present disclosure, a method of manufacturing a semiconductor package having one or more of the above-described features is presented. The method may include providing a die paddle. The method may further include dispensing or printing solder on the die paddle. The method may further include die attaching, optionally including a flip die attaching. The method may further include dispensing or printing solder on a die surface or die back surface. The method may further include attaching one or more further terminals. The method may further include attaching a slug to the die paddle by inserting one or more bended ends of the slug into one or more recessed surfaces of the die paddle and solder print the one or more bended ends to the die paddle. The method may further include moulding whilst exposing a first surface of the slug.

In an embodiment the method may further include providing the one or more stress relief features on the slug as one or more of: a half-cut feature at a transition from a top surface of the slug to the one or more bended ends; a half-cut feature located on a side of the one or more bended ends; and a groove or similar feature.

The semiconductor package of the present disclosure may be used in a source down or drain down, i.e., flipped die, configuration.

### Brief description of the Drawings

Embodiments of the present disclosure will now be described, by way of example only, with reference to the accompanying schematic drawings in which corresponding reference symbol indicate corresponding parts, in which:
Figs. 1A-1E show a top of a first example semiconductor package, with Fig. 1A showing a 2D top view, Fig. 1B showing a 3D top view, Fig. 1C showing a 2D top view of the inside and Figs. 1D-1E showing a 3D top view of the inside;
Figs. 2A-2C show a back of the first example semiconductor package, with Fig. 2A showing a 2D back view, Fig. 2B showing a 3D back view and Fig. 1C showing a 3D back view of the inside;
Figs. 3A-3E show a top of a second example semiconductor package, with Fig. 3A showing a 2D top view, Fig. 3B showing a 3D top view, Fig. 3C showing a 2D top view of the inside and Figs. 3D-3E showing a 3D top view of the inside;
Figs. 4A-4C show a back of the second example semiconductor package, with Fig. 4A showing a 2D back view, Fig. 4B showing a 3D back view and Fig. 4C showing a 3D back view of the inside;
Figs. 5A-5H are side views of example source/drain slabs; and
Fig. 6 shows an example process flow for manufacturing a semiconductor package according to the present disclosure.

The figures are intended for illustrative purposes only, and do not serve as restriction of the scope of the protection as laid down by the claims.

### Detailed description

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure but is merely representative of various embodiments. While the various aspects of the embodiments are presented in drawings, the drawings are not necessarily drawn to scale unless specifically indicated.

The described embodiments are to be considered in all respects only as illustrative and not restrictive. The scope of the present disclosure is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present disclosure should be or are in any single example of the present disclosure. Rather, language referring to the features and advantages is understood to mean that a specific feature, advantage, or characteristic described in connection with an embodiment is included in at least one embodiment of the present disclosure. Thus, discussions of the features and advantages, and similar language, throughout this specification may, but do not necessarily, refer to the same example.

Furthermore, the described features, advantages, and characteristics of the present disclosure may be combined in any suitable manner in one or more embodiments. One skilled in the relevant art will recognize, in light of the description herein, that the present disclosure may be practiced without one or more of the specific features or advantages of a particular embodiment. In other instances, additional features and advantages may be recognized in certain embodiments that may not be present in all embodiments of the present disclosure. Reference throughout this specification to "one embodiment," "an embodiment," or similar language means that a particular feature, structure, or characteristic described in connection with the indicated embodiment is included in at least one embodiment of the present disclosure. Thus, the phrases "in one embodiment," "in an embodiment," and similar language throughout this specification may, but do not necessarily, all refer to the same embodiment.

The present disclosure presents back cooled package, a top cooled package and a dual cooled source down package, e.g., LFPAK package or PQFN package. The packages have in common a slug design, which slug operates as source or drain, depending on the package configuration.

In some configurations, a package may include a dual source pad, exposing the dual source pad on top and back of the package. When heat is generated at the source, the source may be exposed and attached to a slug for better heat dissipation.

In other configurations, a package may include a dual drain pad, exposing the dual drain pad on top and back of the package. When heat is generated at the drain, the drain may be exposed and attached to a slug for better heat dissipation.

The slug operating as source or drain, depending on the configuration, may be designed to provide stress relief to absorb any forces or pressure applied on the slug, which may intentionally be added inside a semiconductor package to improve thermal performance. Advantageously, in an embodiment the slug may be exposed without using film assist moulding or additional package grinding to meet any aimed thermal performance.

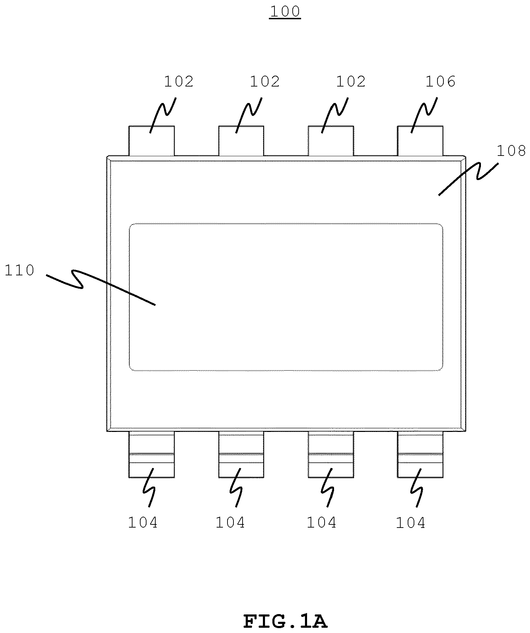

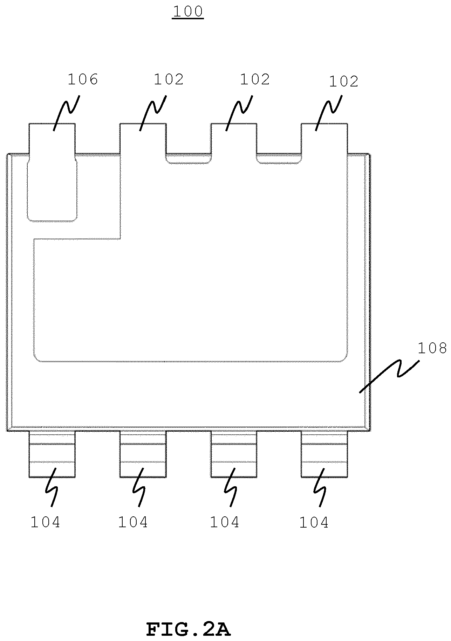

In a first embodiment shown in Figs. 1A-1E and Figs. 2A-2C, an example semiconductor package 100 is presented in a source down configuration (flipped die) with added source slug connected on the die paddle to achieve low RDSon, low inductance and low thermal resistance. Figs. 1A-1E show the top of the package 100 and Figs. 2A-2C show the back of the package 100. In this example, the package 100 is a dual cooled source down LFPAK package, but the present disclosure is not limited to such package and may similarly be applied to, e.g., a PQFN package or any other suitable package.

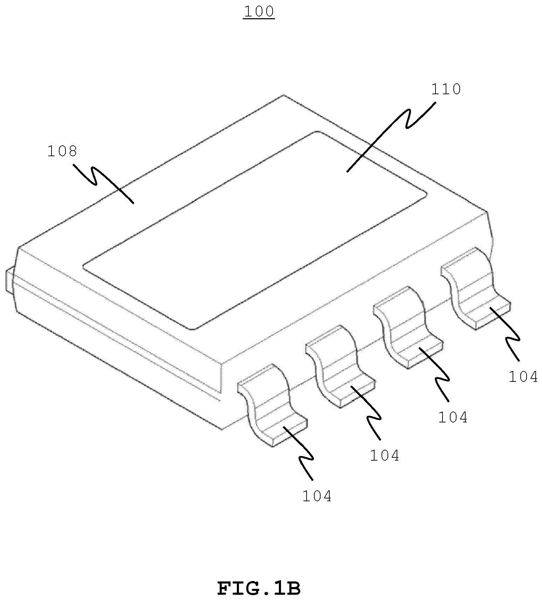

In Fig. 1A and Fig. 1B the outside of the package 100 is shown in a top view. The example package 100 includes three source pins 102, four drain pins 104 and a gate pin 106. The number of pins and the locations thereof may be different, depending on the configuration requirements. An encapsulation 108 protects the internals of the package 100.

Exposed on the outside of the package 100, a source slug 110 covers a large portion of the top part of the package 100 to allow heat dissipation. The source slug 110 is internally electrically connected to the source pins 102.

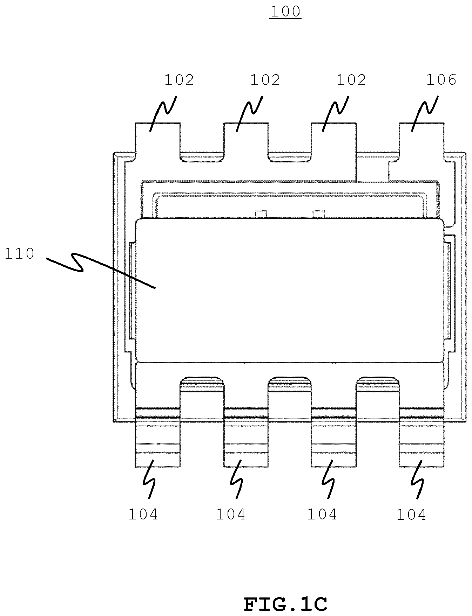

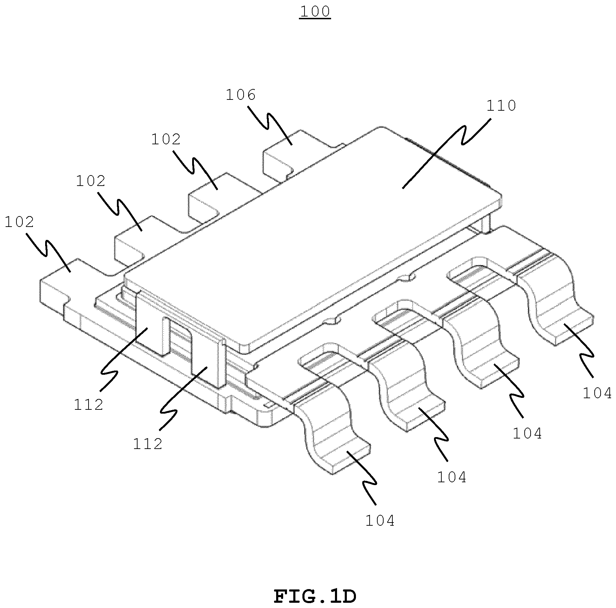

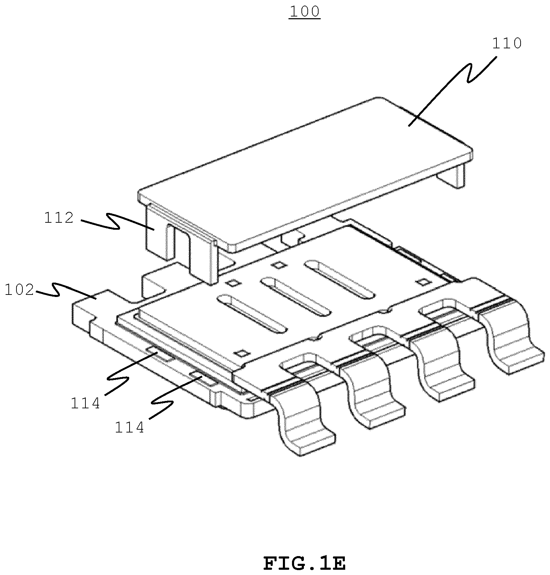

In Fig. 1C and Fig. 1D the inside of the package 100 is shown in a top view, i.e., without the encapsulation 108. The source slug 110 is made of a first conductive metal. The source slug 110 may bend at an angle at one or more ends 112 of the source slug 110, such that the one or more ends 112 can be attached on a recessed surface 114 (see Fig. 1E) of a second conductive metal such as a die paddle for the source. The one or more ends 112 may thus act like legs. The first and second conductive material may be of the same composition. The one or more ends 112 of the source slug 110 may be attached to the recessed surface 114 through soldering, sintering, welding or any similar attach process.

In Fig. 1E the inside of the package 100 is shown with a detached source slug 110. In this view the recessed surfaces 114 are visible. In the example of Fig. 1E, the recessed surfaces 114 are recessed within the die paddle of the source.

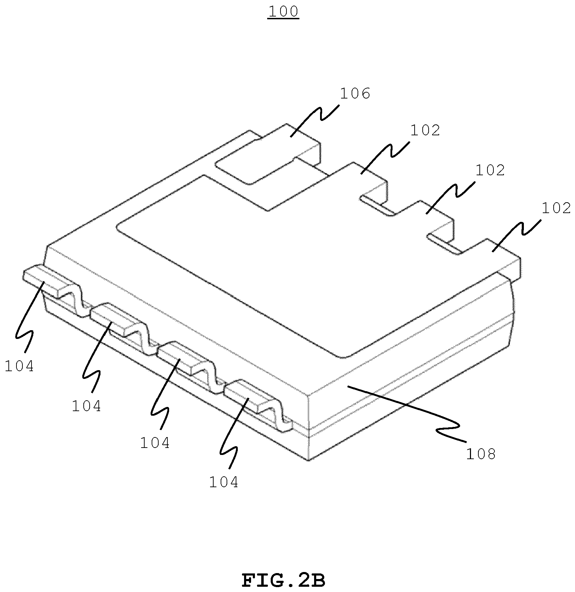

In Fig. 2A and Fig. 2B the outside of the package 100 is shown in a back view. The three source pins 102, the four drain pins 104, the gate pin 106 and the encapsulation 108 are shown. In the example of Fig. 2A, the source is exposed to the back part of the package and includes the source pins 102. The gate is exposed to the back part of the package and includes the gate pin 106.

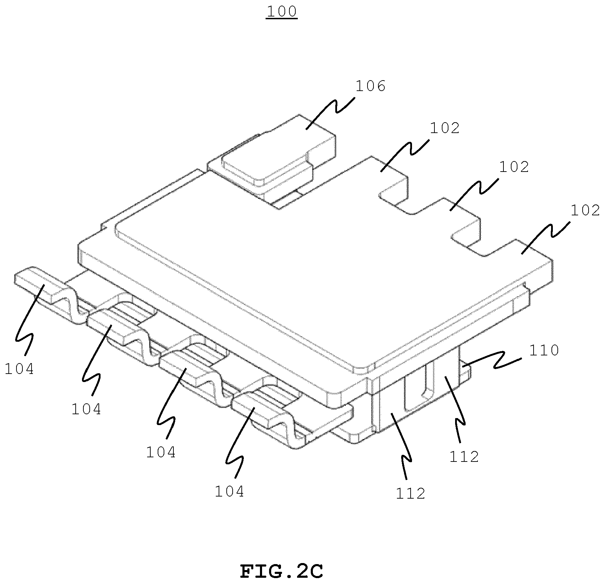

In Fig. 2C the inside of the package 100 is shown in a back view, i.e., without the encapsulation 108. Part of the source slug 110 is visible including bended ends 112.

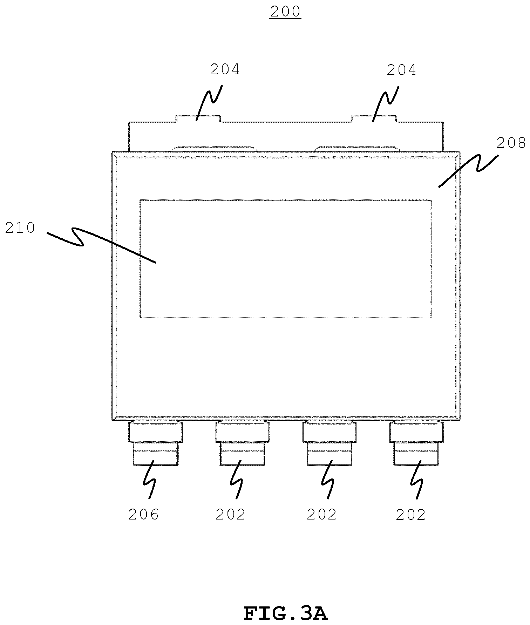

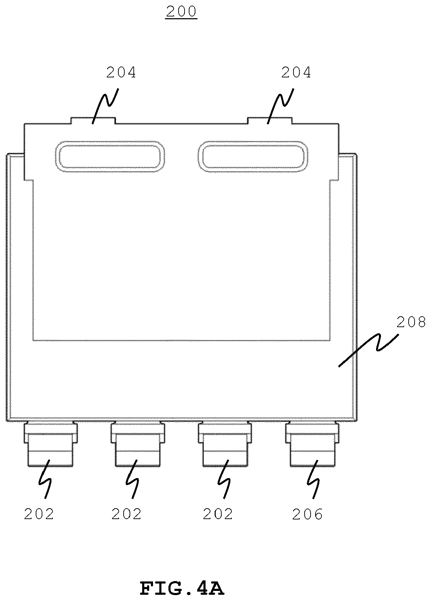

In a second embodiment shown in Figs. 3A-3E and 4A-4C, an example semiconductor package 200 is presented in a drain down configuration (flipped die) with added drain slug connected on the die paddle to achieve low RDSon, low inductance and low thermal resistance. Figs. 3A-3E show the top of the package 200 and Figs. 4A-4C show the back of the package 200. In this example, the package 200 is a dual drain cooled LFPAK package, but the present disclosure is not limited to such package and may similarly be applied to, e.g., a PQFN package or any other suitable package.

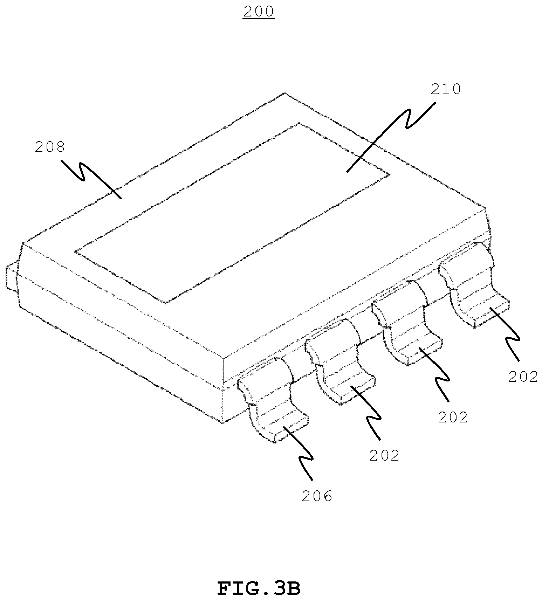

In Fig. 3A and Fig. 3B the outside of the package 200 is shown in a top view. The example package 200 includes three source pins 202, two drain pins 204 and a gate pin 206. The number of pins and the locations thereof may be different, depending on the configuration requirements. An encapsulation 208 protects the internals of the package 200.

Exposed on the outside of the package 200, a drain slug 210 covers a large portion of the top part of the package 200 to allow heat dissipation. The drain slug 210 is internally electrically connected to the drain pins 204.

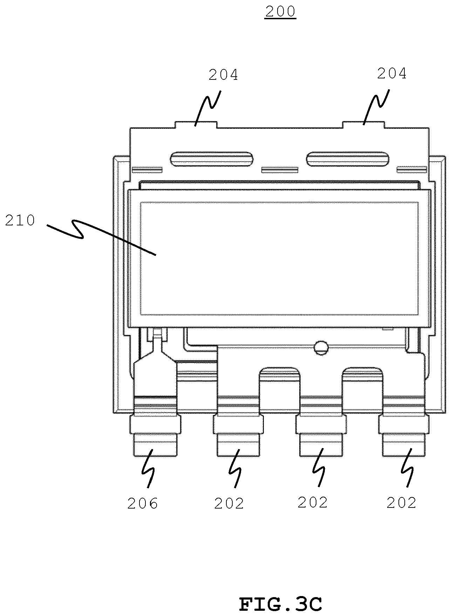

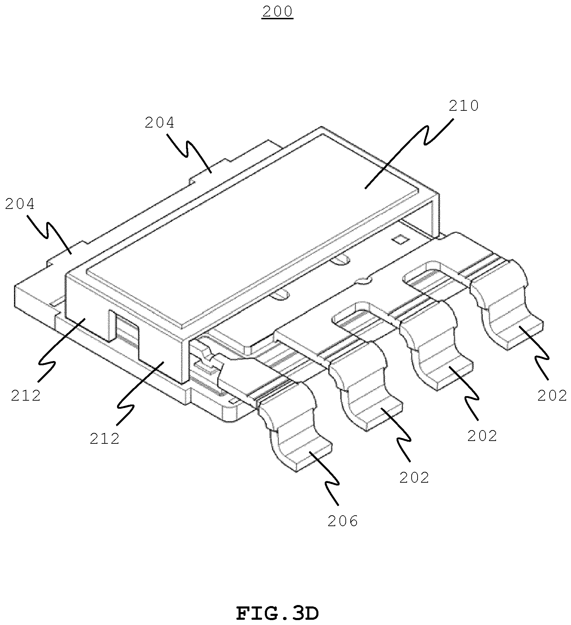

In Fig. 3C and Fig. 3D the inside of the package 200 is shown in a top view, i.e., without the encapsulation 208. The drain slug 210 is made of a first conductive metal. The drain slug 210 may bend at an angle at one or more ends 212 of the drain slug 210, such that the one or more ends 212 can be attached on a recessed surface 214 (see Fig. 2E) of a second conductive metal such as a die paddle for the drain. The one or more ends 212 may thus act like legs. The first and second conductive material may be of the same composition. The one or more ends 212 of the drain slug 210 may be attached to the recessed surface 214 through soldering, sintering, welding or any similar attach process.

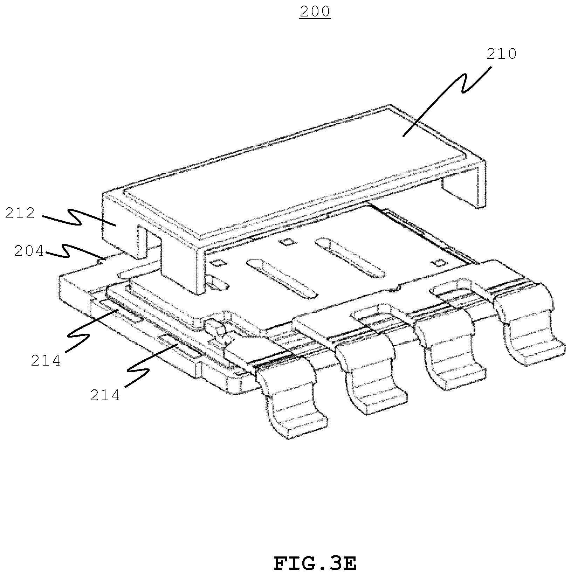

In Fig. 3E the inside of the package 200 is shown with a detached drain slug 210. In this view the recessed surfaces 214 are visible. In the example of Fig. 3E, the recessed surfaces 214 are recessed within the die paddle of the drain.

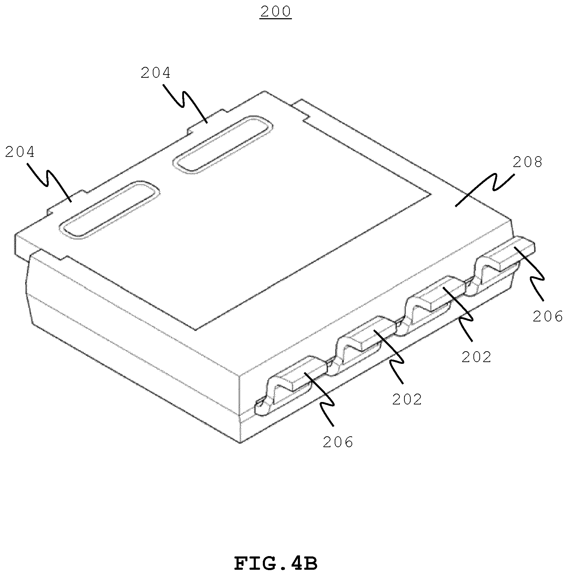

In Fig. 4A and Fig. 4B the outside of the package 200 is shown in a back view. The three source pins 202, the two drain pins 204, the gate pin 206 and the encapsulation 208 are shown. In the example of Fig. 4A, the drain is exposed to the back part of the package and includes the source pins 202.

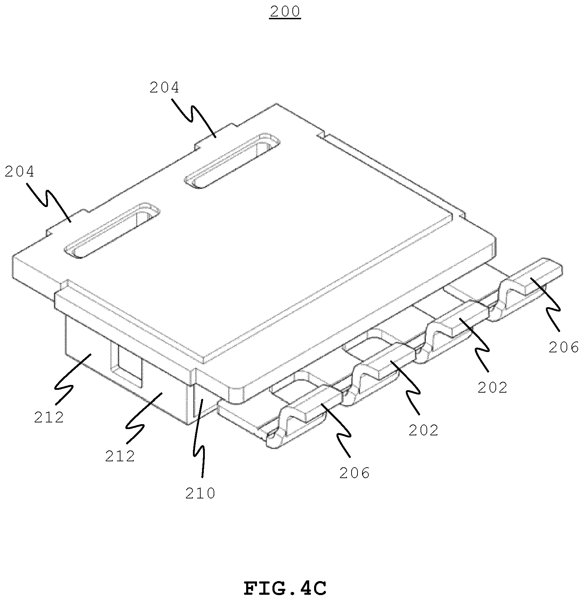

In Fig. 4C the inside of the package 200 is shown in a back view, i.e., without the encapsulation 208. Part of the source slug 210 is visible including bended ends 212.

The terminals 102, 104, 106, 202, 204, 206, other than the slug terminals 110, 210, are extended outside the package body and may be formed in either a gull wing or micro leads, leadless or combination of both geometries.

The source slug 110 may be attached with the source terminals 102 using conductive materials/metal such as copper, either bare or plated such as Ag, Sn, Ti, Ni, etc. Similarly, the drain slug 210 may be attached with the drain terminals 204 using such conductive materials/metal. As illustrated in the figures, the drain/source slug 110, 210 are preferably attached via recessed surfaces 114, 214.

A first surface of the source/drain slug 110, 210 may be exposed on the top surface of the package through direct or indirect touch with mould cavities, while the second surface of the source/drain slug 110, 210 faces towards a semiconductor silicon die. Preferably, the second surface of the source/drain slug 110, 210 is as close as possible to the semiconductor die, e.g., 100um or less, such as the heat transfer generated from the source/drain slug 110, 210 may be maximized.

The first, outer surface of the source/drain slug 110, 210, if not contacting the mould cavity, may be exposed using a package grinding process or similar polishing technique to expose the top surface.

A second conductive metal, acting as second source in the first embodiment or acting as second drain in the second embodiment, may have its first surface exposed at the back of the package, with its second surface act as die paddle, connecting the source terminal in the first embodiment or the drain terminal in the second embodiment of a flipped semiconductor die.

Thus, a semiconductor package 100 may be obtained using a standard or flipped chip process, forming a source down configuration with added slug 110, acting as the first source, attached at the main or second source terminal(s) 102. Similarly, a semiconductor package 200 may be obtained using a standard or flipped chip process, forming a drain down configuration with added slug 210, acting as the first drain, attached at the main or second drain terminal(s) 204. The fist surface of the first conductive metal forming the source/drain slug 110, 210 may be exposed on the top surface of the package through direct or indirect touch with mould cavities, while the second surface of the source/drain slug 110, 210 faces towards a semiconductor silicon die before moulding. The first surface of the first conductive metal of the source/drain slug, if not contacting the top mould cavity, may be exposed using a package grinding process. The second conductive metal, acting as second source or second drain, depending on the configuration, may have its first surface exposed at the back of the package 100, 200 and the second surface of the second conductive metal may act as the die paddle for a flipped semiconductor die.

Depending on the package orientation, the package 100, 200 may form a back cooled or a top cooled package.

In an embodiment, the bended ends 112, 212 of the source/drain slug 110, 210 may be designed to act as force/stress relief or absorber during moulding process. Hereto, the bended ends 112, 212 may include a half-cut feature at the transition from the top surface of the source/drain slug 110, 210 to the bended ends 112, 212. In another example, the bended ends 112, 212 may include a half-cut feature located on the sides of the bended legs. In another example, the bended ends 112, 212 may include a groove or similar feature. One or more of these stress relief features may be combined in a single bended end 112, 212.

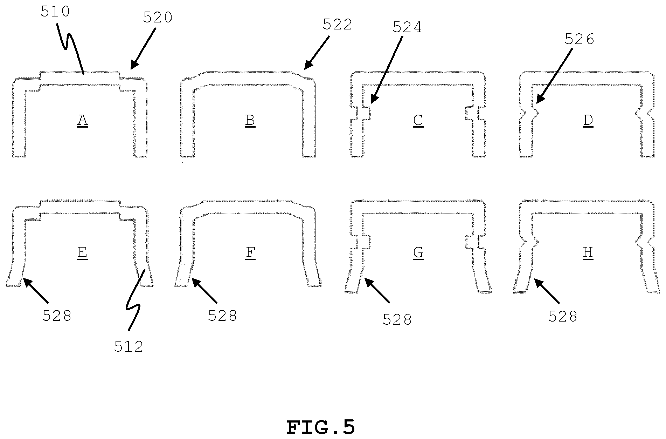

Fig. 5 shows various, non-limiting examples A-H of source/drain slugs including such stress relief features. Each of the examples A-H shows a slug, which may be used as source slug 110 or drain slug 210 depending on the configuration of the semiconductor package. Each source/drain slug may include a first conductive metal surface 510 and one or more bended ends 512 acting as legs of the source/drain slug 110, 210.

In the example of Fig. 5A, the bended ends 512 include a half-cut feature 520 at the transition from the top surface 510 to the bended ends 512.

In the example of Fig. 5B, the bended ends 512 include a sloped transition 522 between the top surface 510 and the bended ends 512.

In the example of Fig. 5C, the bended ends 512 include a half-cut feature 524 located on the sides of the bended legs.

In the example of Fig. 5D, the bended ends 512 include a groove or similar feature 526 located on the sides of the bended legs.

The bended ends 512 may be bended substantially perpendicular to the top surface 510, such as shown in the examples of Figs. 5A-5D. Alternatively, part or all of the bended ends 512 may bend further outwards, such as shown in Figs. 5E-5H, which examples are similar to Figs. 5A-5D, respectively, except for the further outward bending 528.

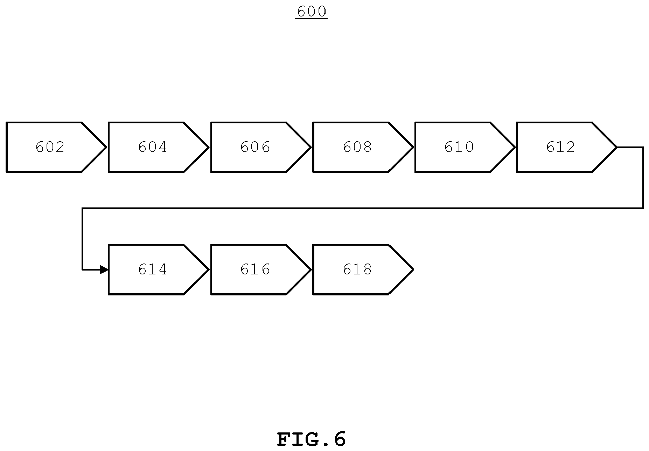

An example process flow 600 for manufacturing a semiconductor package 100, 200 including a source/drain slug 110, 210 according to the present disclosure is shown in Fig. 6. In step 602 a die paddle may be provided. In step 604, solder may be dispensed or printed on the die paddle. Step 606 may include a die attach process, possibly a flip die attach depending on the configuration of the semiconductor package. In step 608, solder may be dispensed or printed on the die surface or die back surface, depending on the configuration of the semiconductor package. In step 610 the drain clips 104 or source clips 202 may be attached, depending on the configuration of the semiconductor package.

In step 612, the source/drain slug 110, 210 (depending on the configuration of the semiconductor package) may be attached to the die paddle. Hereto, the bended ends 112, 212 of the source/drain slug 110, 210 may be inserted into the recessed surfaces 114, 214 and solder printed to the die paddle.

Step 614 involves a reflow. Step 616 involves a moulding process, optionally including a polishing to expose the first, top surface of the source/drain slug 110, 210. Step 618 involves a plating/trim/form/singulation process step.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope thereof.

## Claims

1. A semiconductor package comprising:
a first terminal exposed on a back surface of the semiconductor package;
one or more further terminals extending outside the semiconductor package; and
a second terminal exposed on a top surface of the semiconductor package,
wherein the second terminal comprises a slug acting as the second terminal,
wherein the slug is electrically attached to the first terminal via one or more bended ends of the slug,
and wherein the slug comprises one or more stress relief features.

2. The semiconductor device according to claim 1, wherein the one or more stress relief features comprises one or more of:
a half-cut feature at a transition from a top surface of the slug to the one or more bended ends;
a half-cut feature located on a side of the one or more bended ends; and
a groove or similar feature.

3. The semiconductor device according to claim 1 or claim 2, wherein the one or more bended ends are bended at an angle to a top surface of the slug, preferably at a perpendicular angle, optionally including a portion that is bended further outwards.

4. The semiconductor package according to any one of the preceding claims, wherein the one or more bended ends form legs of the slug.

5. The semiconductor package according to any one of the preceding claims,
wherein the first terminal is formed by a paddle die,
wherein the paddle die comprises one or more recessed surfaces for receiving the one or more bended ends,
and wherein the one or more bended ends are solder printed to the one or more recessed surfaces.

6. The semiconductor package according to any one of the claims 1-5, wherein a first surface of the slug is exposed on the top surface of the semiconductor package, while a second surface of the slug is facing towards a semiconductor silicon die before moulding.

7. The semiconductor package according to claim 6, wherein the first surface of the slug is exposed on the top surface of the semiconductor package through direct or indirect touch with mould cavities.

8. The semiconductor package according to any one of the claims 1-5, wherein a first surface of the slug, if not contacting a top mould cavity, has been exposed using a package grinding process.

9. The semiconductor package according to any one of the preceding claims,
wherein the first terminal comprises a first surface exposed at the back of the semiconductor package,
and wherein the first terminal comprises a second surface acting as die paddle for a flipped semiconductor die.

10. The semiconductor package according to any one of the preceding claims, further comprising one or more further terminals extending outside the semiconductor package and formed in either a gull wing or micro leads, or leadless, or in a combination of both geometries.

11. The semiconductor package according to claim 10, wherein the first terminal and the second terminal are source terminals, and wherein the one or more further terminals comprises one or more drain terminals and one or more gate terminals.

12. The semiconductor package according to claim 10, wherein the first terminal and the second terminal are drain terminals, and wherein the one or more further terminals comprises one or more source terminals and one or more gate terminals.

13. The semiconductor package according to any one of the preceding claims, forming a metal-oxide-semiconductor field-effect transistor, MOSFET.

14. A method of manufacturing a semiconductor package according to any one of the claims 1-13, comprising:
providing a die paddle;
dispensing or printing solder on the die paddle;
die attaching, optionally comprising a flip die attaching;
dispensing or printing solder on a die surface or die back surface;
attaching one or more further terminals;
attaching a slug to the die paddle by inserting one or more bended ends of the slug into one or more recessed surfaces of the die paddle and solder print the one or more bended ends to the die paddle, wherein the slug comprises one or more stress relief features; and
moulding whilst exposing a first surface of the slug.

15. The method according to claim 14, further comprising providing the one or more stress relief features on the slug as one or more of:
a half-cut feature at a transition from a top surface of the slug to the one or more bended ends;
a half-cut feature located on a side of the one or more bended ends; and
a groove or similar feature.
